# EUROPEAN PATENT SPECIFICATION

(11) **EP 1 580 296 B1**
(45) Date of publication and mention of the grant of the patent: **02.01.2008**
(21) Application number: 05251745.5
(22) Date of filing: 22.03.2005
(51) Int. Cl.: C23C 14/06, F01D 5/28, C23C 28/00

(54) **Reduced thermal conductivity TBC by EB-PVD process to incorporate porosity**
Verfahren zur Herstellung einer porösen Beschichtung
Procédé de fabrication d'un couche poreuse

(30) Priority: 22.03.2004 US 805922
(43) Date of publication of application: 28.09.2005
(73) Proprietor: United Technologies Corporation, Hartford, Connecticut 06101 (US)
(72) Inventor: Ulion, Nicholas E., Marlborough CT 06447 (US); Broadhurst, Donald, East Hartford CT 06118 (US); Maloney, Michael J., Marlborough CT 06447 (US); Clavette, Claude J., Madawaska ME 04756 (US); Litton, David A., Rocky Hill CT 06067 (US); Trubelja, Mladen, Manchester CT 06040 (US)
(74) Representative: Hall, Matthew Benjamin

(56) References cited:
- EP-A- 1 327 698
- WO-A-20/04043691
- US-A- 5 624 721
- US-A- 5 824 423
- US-A1- 2003 211 354

## Description

The invention relates to a method for reducing thermal conductivity in coatings by increasing the porosity of the coating. More particularly, the invention relates to a method of increasing the porosity of a ceramic coating through the introduction of a fugitive material which is liberated when heat treated forming pores.

This invention relates to thermal barrier coatings (TBC) in general, and particularly to those made from ceramic materials, and to metallic parts having such thermal barrier coatings. The thermal barrier coatings have particular utility in gas turbine engines.

Gas turbine engines are well developed mechanisms for converting chemical potential energy, in the form of fuel, to thermal energy and then to mechanical energy for use in propelling aircraft, generating electrical power, pumping fluids, etc. At this time, the major available avenue for improved efficiency of gas turbine engines appears to be the use of higher operating temperatures. However, the metallic materials used in gas turbine engines components are currently very near the upper limits of their thermal stability. In the hottest portion of modern gas turbine engines, metallic materials are used at gas temperatures above their melting points. They survive because they are air cooled. But providing air cooling reduces engine efficiency.

Accordingly, there has been extensive development of thermal barrier coatings for use with cooled gas turbine aircraft hardware. By using a thermal barrier coating, the amount of cooling air required can be substantially reduced, thus providing a corresponding increase in efficiency.

One common thermal barrier coating (TBC) consists of a yttria stabilized zirconia ceramic known as 7YSZ. 7YSZ typically exhibits a thermal conductivity of approximately 2.2 W/m°C. It would be preferable to reduce this thermal conductivity to below 1.1 W/m°C, or about half of that of pure 7YSZ. Preferably the method chosen to accomplish such a diminution of thermal conductivity will not increase the mass of the coating. Because coatings are often applied to the airfoils of rotating parts, small increases in the mass of the coating can result in large forces being applied to the rotating part. Therefore, an ideal coating would couple reduced thermal conductivity with reduced mass.

Accordingly, it is an object of the present invention to provide a method for reducing thermal conductivity in coatings by increasing the porosity of the coating. More particularly, the invention relates to a method of increasing the porosity of a ceramic coating through the introduction of a fugitive material which is liberated when heat treated forming pores.

It is known to provide porosity in a thermal barrier material during an EBPVD process using a fugitive material from EP-A-1327698 and US-A-5624721. It is also known to provide porosity in a material deposited by a thermal spray process which can be graded, as shown in US-A-5824423, or to spray the layers with and without a fugitive material to create differing levels of porosity, as shown in US-A-2003/0211354.

In accordance with the present invention, there is provided a method of reducing thermal conductivity in thermal barrier coatings (TBC) which are deposited via an electron beam physical vapor deposition process (EB-PVD) through the incorporation of porosity comprising the steps of:
building up a thermal barrier coating by depositing alternating layers of thermal barrier material upon a part by EBPVD, the deposition process comprising alternatingly depositing:
   a mixture comprising a TBC matrix and a first percentage of fugitive material upon the part to form first layers; and
   a TBC matrix and a second different percentage of fugitive material upon the part to form second layers,
   whereby multiple alternate layers of said mixture of a matrix TBC and a fugitive material are deposited upon the part, and
heating said layers at a temperature and for a duration sufficient to liberate a portion of said fugitive material to form a porous network. The method results in a coating layer which comprises a TBC matrix, and a porous network extending through the TBC matrix.

Preferred embodiments of the invention will now be described, by way of example only, and with reference to the accompanying drawings in which:
FIG. 1 is a photograph of an exemplary combination of matrix TBC and fugitive material for use in EB-PVD according to the method of the present invention
FIG. 2 is a photomicrograph of the porosity formed in a 7YSZ coating utilizing a molybdenum fugitive material according to the method of the present invention.
FIG. 3 is a photomicrograph of the porosity formed in a 7YSZ coating utilizing a carbon fugitive material according to the method of the present invention.

Like reference numbers and designations in the various drawings indicate like elements.

It is a teaching of the present invention to provide a method for creating a thermal barrier coating (TBC) with a reduced thermal conductivity resulting from the fabrication of a porous microstructure in the TBC. The porous structure is achieved through the co-evaporation of a fugitive material with the matrix TBC onto a part to be coated. Heat treatment of the co-evaporated deposition results in the liberation of the fugitive phase material leaving behind a porous network structure. The porous structure results in both a lowered thermal conductivity and reduced mass.

The matrix TBC may consist of any ceramic material that does not interact with the fugitive material in such a way that the fugitive material cannot be removed after deposition of the TBC. Preferred ceramics include carbides, nitrides, silicides, and zirconium based ceramics. In particular, yttria stabilized zirconia (7YSZ) is a widely used matrix TBC which is well suited to the method of the present invention.

As noted above, the method of the present invention involves the co-evaporation of a "matrix" TBC oxide along with a fugitive material in a predetermined ratio. Subsequent to co-evaporation, a post-coating, alloy friendly, oxidation heat treatment is used to liberate the fugitive material from the coating, leaving a porous structure. By "alloy friendly" it is meant that the maximum temperature at which the heat treatment is performed is below the melting temperature of the alloy from which the coated part is created. Preferably, the maximum temperature at which the heat treatment is performed is below the incipient melting point of any and all portions of the coated part exposed to the heat treatment. For the heat treatment of parts composed of nickel based alloys, maximum heat treatment temperatures typically range from 1750°F (955°C) to 2100°F (1150°C).

It is required that the fugitive material be predominately stable in the deposition environment but easily removed (i.e. unstable) following the coating deposition step. The fugitive material must be compatible with the TBC oxide and the very high processing temperatures typical of EB-PVD coatings. By "compatible" it is meant that the fugitive material is not such as to alloy or diffuse into the TBC ceramic. While the present invention is therefore broadly drawn to encompass any and all compatible fugitive materials, three materials which form desired volatile decomposition products under typical post-coating heat exposure conditions, namely oxidation at a relatively low temperature in an atmospheric environment, are carbon, molybdenum and tungsten.

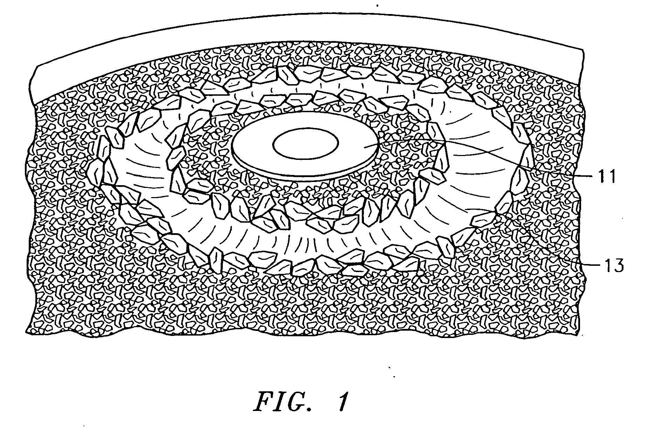

In practice, both the matrix TBC and the fugitive material are deposited in layers upon the part to be coated. The matrix TBC and the fugitive material are deposited through a process of electron beam physical vapor deposition (EB-PVD). Various methods may be employed to achieve the deposition of the matrix TBC and the fugitive material in desired proportions. In one embodiment, particulate ceramic and a solid piece of fugitive material is utilized. Such an exemplary configuration is illustrated with reference to Fig. 1. Molybdenum disk 11 is surrounded, post EB-PVD, by solidified 7YSZ. During evaporation, an electron beam is directed in alternating fashion at the Molybdenum disk 11 and the particulate 7YSZ.

In another embodiment, preformed ingots of the matrix TBC and the fugitive material are utilized as the source of the coating vapor.

As a result of the method described above, multiple layers of a matrix TBC oxide and at least one fugitive material can be deposited upon a part. Each individual layer contains a different percentage mixture of fugitive material resulting in a predetermined post-heating porosity. In one embodiment, there is alternatingly deposited upon the part at least one layer containing a fugitive material and at least one layer containing no fugitive material. As a result, post heat treatment, there exists at least one layer of the resulting TBC of a density undiminished by the liberation of a fugitive material.

The amount of porosity within a layer is controllable based on the ratio of fugitive to matrix material evaporated in the co-evaporation step. Microstructures, such as continuously porous or graded porosity coatings can be produced. To produce graded porosity coatings, multi-source EB-PVD is performed whereby the intensity of the electron beam used to vaporize the fugitive material is varied in accordance with the desired amount of gradation. When employing a dual-or multi-source coating process, the initial and final layers of the deposited TBC may be of higher density or different composition than the matrix TBC (depending on the number of evaporation sources employed) to further enhance the characteristics of the TBC system. For example, selection of different material layers to optimize oxidation resistance, TBC adherence and erosion/impact resistance is possible. Such material layers may consist of, but are not limited to, yttria-stabilized zirconia or alumina.

Example: EB-PVD of 7YSZ as the matrix TBC oxide with either Carbon or Molybdenum as fugitives materials was successfully deposited in a layer upon a part made of a nickel-based alloy. Both materials proved sufficiently stable during the EB-PVD process environment to function in the desired manner. That is, they were co-evaporated, deposited and subsequently, removed (2050F/4 hour/air post-coat heat treatment) to produce a pore structure having a 27% volume fraction as compared to pure 7YSZ. The thermal conductivity was measured to be 1.1 W/m°C.

With reference to Figure 1 there is illustrated the crucible configuration utilized to evaluate the EB-PVD fugitive phase process. The basic approach is the same for any of the above candidate fugitive materials. In the photograph, the molybdenum disc is located at the center of the crucible, surrounded by the ceramic particulate. The 7YSZ and fugitive materials are co-evaporated by manipulation of the electron beam. Alternating layers, of "dense" and "porous" TBC were evaporated. In addition, a coating deposition program was followed to provide initial and final application of dense (ie. "substantially pure") 7YSZ, to promote TBC adherence and erosion resistance. Furthermore, the deposition program was modified to produce both a "continuous" and a "graded" porosity as described above.

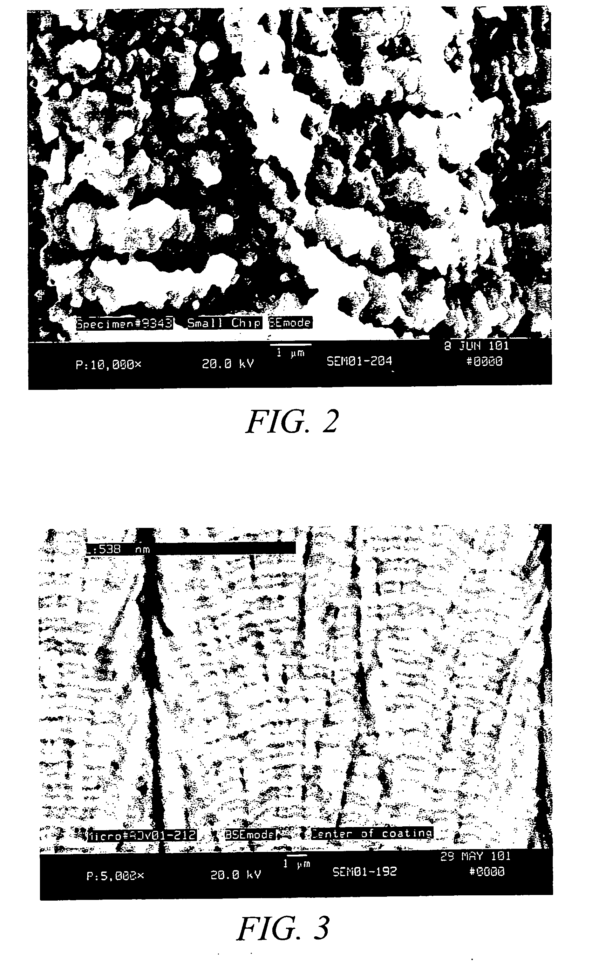

Figures 2 and 3 are SEM photomicrographs illustrating the type of 7YSZ coating microstructures achieved with molybdenum and carbon fugitives, respectively. As is visually apparent, the width of the individual pores formed using either fugitive is approximately between 10-100 nanometers. While individual pores measure approximately 10-100 nanometers in diameter, the total reduction in mass of the matrix TBC per unit volume was shown to range from 5% to 40%.

While a greater percentage reduction in the mass of the matrix TBC resulting from porosity results in greater reductions in thermal conductivity, there must be balanced a concern for the weakened physical properties of the TBC arising from the removal of fugitive materials. It is therefore preferred that a fugitive material be employed to provide an approximate pore size of between 10-100 nanometers in an amount sufficient to result, post liberation, in the removal of no more than 70% by weight of the matrix TBC. While a 100% evacuation of the fugitive material form the co-evaporated combination of the fugitive material and the matrix TBC is preferred, it is sufficient that at least 90% of the fugitive material is liberated and removed from the TBC.

## Claims

1. A method of reducing thermal conductivity in thermal barrier coatings (TBC) which are deposited via an electron beam physical vapor deposition process (EB-PVD) through the incorporation of porosity comprising the steps of:
building up a thermal barrier coating by depositing alternating layers of thermal barrier material upon a part by EBPVD, the deposition process comprising alternatingly depositing:
a mixture comprising a TBC matrix and a first percentage of fugitive material upon the part to form first layers; and
a TBC matrix and a second different percentage of fugitive material upon the part to form second layers,
whereby multiple alternate layers of mixture of a matrix TBC and a fugitive material are deposited upon the part, and
heating said layers at a temperature and for a duration sufficient to liberate a portion of said fugitive material to form a porous network.

2. The method of claim 1 wherein the second layers are free of fugitive material.

3. The method of claim 1 or 2 wherein said depositing said TBC matrix comprises depositing a ceramic selected from the group consisting of 7YSZ, carbides, nitrides, silicides, and zirconium based ceramics.

4. The method of claim 1, 2 or 3 wherein said depositing said fugitive material comprises depositing a fugitive material selected from the group comprising carbon, molybdenum and tungsten.

5. The method of any preceding claim wherein said depositing said mixture via EB-PVD comprises utilizing particulate TBC matrix and particulate fugitive material.

6. The method of any of claims 1 to 4 wherein said depositing said mixture via EB-PVD comprises utilizing an ingot of said TBC matrix and an ingot of said fugitive material.

7. The method of claim 5 or 6 wherein the mixture is deposited by co-evaporating the TBC matrix and fugitive materials through directing the electron beam in an alternating fashion at the materials.

8. The method of any preceding claim wherein said heating comprises heating said layers to a temperature less than the melting temperature of the part.

9. The method of any of claims 1 to 7 wherein said heating comprises heating said layers to a temperature less than the incipient melting point of the part.

10. The method of any of claims 1 to 7 wherein said heating comprises heating said layers to a temperature between approximately 1750°F (955°C) and 2100°F (1150°C).

11. The method of any of claims 1 to 7 wherein said heating comprises heating said layers to a temperature and for a duration sufficient to liberate at least 90% of said fugitive material.

12. The method of any preceding claim wherein said depositing said mixture comprises the steps of altering the rate at which said TBC matrix and said fugitive material is deposited to form said first layers and heating said layers to produce a layer having a gradation of porosity.

13. The method of any preceding claim wherein said heating comprises heating said layers to produce said porous network comprising a volume not greater than 40% of said layer by volume.

14. The method of any preceding claim wherein said porous network is comprised of a plurality of pores each having a width between ten and one hundred nanometers.

15. The method of any preceding claim wherein said depositing step comprises depositing said mixture upon a gas turbine engine component.

## Patentansprüche

1. Verfahren zum Verringern der Wärmeleitfähigkeit in Wärmebarrierebeschichtungen (TBC), die durch einen Prozess der physikalischen Dampfabscheidung mittels Elektronenstrahl (EB-PVD) abgeschieden werden, durch die Inkorporierung von Porosität, folgende Schritte aufweisend:
Aufbauen einer Wärmebarrierebeschichtung durch Abscheiden abwechselnder Schichten aus Wärmebarrierematerial auf einem Teil durch EB-PVD, wobei der Abscheidungsprozess aufweist, dass abwechselnd abgeschieden wird:
ein Gemisch, das eine TBC-Matrix und einen ersten Prozentsatz an flüchtigem Material aufweist, auf dem Teil, um erste Schichten zu bilden; und
eine TBC-Matrix und ein zweiter unterschiedlicher Prozentsatz an flüchtigem Material auf dem Teil, um zweite Schichten zu bilden,
wodurch mehrere abwechselnde Schichten von Gemisch aus einer Matrix-TBC und flüchtigem Material auf dem Teil abgeschieden werden, und
Erhitzen der Schichten bei einer Temperatur und für eine Dauer, die ausreichend sind, um einen Teil des flüchtigen Materials freizusetzen, um ein poröses Netzwerk auszubilden.

2. Verfahren nach Anspruch 1, bei dem die zweiten Schichten frei von flüchtigem Material sind.

3. Verfahren nach Anspruch 1 oder 2, bei dem das Abscheiden der TBC-Matrix ein Abscheiden einer Keramik, die ausgewählt wird aus der Gruppe, die aus 7YSZ, Carbiden, Nitriden, Siliciden und Keramiken auf Zirconium-Basis besteht, aufweist.

4. Verfahren nach Anspruch 1, 2 oder 3, bei dem das Abscheiden des flüchtigen Materials ein Abscheiden eines flüchtigen Materials, das ausgewählt wird aus der Gruppe, die Kohlenstoff, Molybdän und Wolfram umfasst, aufweist.

5. Verfahren nach irgendeinem vorangehenden Anspruch, bei dem das Abscheiden des Gemisches durch EB-PVD ein Verwenden einer teilchenförmigen TBC-Matrix und eines teilchenförmigen flüchtigen Materials aufweist.

6. Verfahren nach irgendeinem der Ansprüche 1 bis 4, bei dem das Abscheiden des Gemisches durch EB-PVD ein Verwenden eines Ingots der TBC-Matrix und eines Ingots des flüchtigen Materials aufweist.

7. Verfahren nach Anspruch 5 oder 6, bei dem das Gemisch durch gemeinsames Verdampfen der TBC-Matrix und des flüchtigen Materials, indem der Elektronenstrahl in abwechselnder Weise auf die Materialien gerichtet wird, abgeschieden wird.

8. Verfahren nach irgendeinem vorangehenden Anspruch, bei dem das Erhitzen ein Erhitzen der Schichten auf eine Temperatur aufweist, die niedriger ist als die Schmelztemperatur des Teils.

9. Verfahren nach irgendeinem der Ansprüche 1 bis 7, bei dem das Erhitzen ein Erhitzen der Schichten auf eine Temperatur aufweist, die niedriger ist als die Temperatur des ersten Anschmelzens des Teils.

10. Verfahren nach irgendeinem der Ansprüche 1 bis 7, bei dem das Erhitzen ein Erhitzen der Schichten auf eine Temperatur zwischen näherungsweise 1750°F (955°C) und 2100°F (1150°C) aufweist.

11. Verfahren nach irgendeinem der Ansprüche 1 bis 7, bei dem das Erhitzen ein Erhitzen der Schichten auf eine Temperatur und für eine Dauer, die ausreichend sind, um mindestens 90% des flüchtigen Materials freizusetzen, aufweist.

12. Verfahren nach irgendeinem vorangehenden Anspruch, bei dem das Abscheiden des Gemisches die Schritte des Veränderns der Rate, mit der die TBC-Matrix und das flüchtige Material abgeschieden werden, um die ersten Schichten zu bilden, und des Erhitzens der Schichten, um eine Schicht mit einer Porositäts-Abstufung zu erzeugen, aufweist.

13. Verfahren nach irgendeinem vorangehenden Anspruch, bei dem das Erhitzen ein Erhitzen der Schichten, um das poröse Netzwerk, das ein Volumen von nicht größer als 40 Vol.-% der Schicht aufweist, zu erzeugen, aufweist.

14. Verfahren nach irgendeinem vorangehenden Anspruch, bei dem das poröse Netzwerk aus einer Mehrzahl von Poren besteht, von denen jede eine Weite zwischen 10 und 100 nm hat.

15. Verfahren nach irgendeinem vorangehenden Anspruch, bei dem der Schritt des Abscheidens ein Abscheiden des Gemisches auf einem Gasturbinenmaschinen-Bauteil aufweist.

## Revendications

1. Procédé de réduction de la conductivité thermique dans des revêtements formant barrière thermique (TBC) qui sont déposés via un procédé de dépôt physique en phase vapeur par faisceau d'électrons (EB-PVD) par l'incorporation de porosité, qui comprend les étapes suivantes :
accumuler un revêtement formant barrière thermique par dépôt de couches alternées de matériau formant barrière thermique sur une pièce par EBPVD, le procédé de dépôt comprenant le dépôt alterné :
d'un mélange comprenant une matrice de TBC et d'un premier pourcentage de matériau éphémère sur la pièce pour former les premières couches ; et
d'une matrice de TBC et d'un second pourcentage différent de matériau éphémère sur la pièce pour former les deuxièmes couches,
moyennant quoi de multiples couches alternées de mélange d'un TBC matriciel et d'un matériau éphémère sont déposées sur la pièce, et
le chauffage desdites couches à une température et pendant une durée suffisantes pour libérer une partie dudit matériau éphémère pour former un réseau poreux.

2. Procédé selon la revendication 1, dans lequel les secondes couches sont dépourvues de matériau éphémère.

3. Procédé selon la revendication 1 ou 2, dans lequel ledit dépôt de ladite matrice de TBC comprend le dépôt d'une céramique choisie dans le groupe constitué par le 7YSZ, les carbures, les nitrures, les siliciures, et les céramiques à base de zirconium.

4. Procédé selon la revendication 1, 2 ou 3, dans lequel ledit dépôt dudit matériau éphémère comprend le dépôt d'un matériau éphémère choisi dans le groupe constitué par le carbone, le molybdène et le tungstène.

5. Procédé selon l'une quelconque des revendications précédentes, dans lequel ledit dépôt dudit mélange via EB-PVD comprend l'utilisation d'une matrice de TBC particulaire et d'un matériau éphémère particulaire.

6. Procédé selon l'une quelconque des revendications 1 à 4, dans lequel ledit dépôt dudit mélange via EB-PVD comprend l'utilisation d'un lingot de ladite matrice de TBC et un lingot dudit matériau éphémère.

7. Procédé selon la revendication 5 ou 6, dans lequel le mélange est déposé par co-évaporation de la matrice de TBC et des matériaux éphémères par orientation du faisceau électronique de manière alternée sur les matériaux.

8. Procédé selon l'une quelconque des revendications précédentes, dans lequel ledit chauffage comprend le chauffage desdites couches à une température inférieure à la température de fusion de la pièce.

9. Procédé selon l'une quelconque des revendications 1 à 7, dans lequel ledit chauffage comprend le chauffage desdites couches à une température inférieure à la température de début de fusion de la pièce.

10. Procédé selon l'une quelconque des revendications 1 à 7, dans lequel ledit chauffage comprend le chauffage desdites couches à une température comprise approximativement entre 1750°F (955°C) et 2100°F (1 150°C).

11. Procédé selon l'une quelconque des revendications 1 à 7, dans lequel ledit chauffage comprend le chauffage desdites couches à une température et pendant une durée suffisantes pour libérer au moins 90 % dudit matériau éphémère.

12. Procédé selon l'une quelconque des revendications précédentes, dans lequel ledit dépôt dudit mélange comprend les étapes consistant à modifier le taux auquel ladite matrice de TBC et ledit matériau éphémère sont déposés pour former lesdites premières couches et ledit chauffage desdites couches pour produire une couche ayant une gradation de porosité.

13. Procédé selon l'une quelconque des revendications précédentes, dans lequel ledit chauffage comprend le chauffage desdites couches pour produire ledit réseau poreux comprenant un volume pas supérieur à 40 % de ladite couche en volume.

14. Procédé selon l'une quelconque des revendications précédentes, dans lequel ledit réseau poreux est composé d'une pluralité de pores ayant chacun une largeur comprise entre 10 et 100 nanomètres.

15. Procédé selon l'une quelconque des revendications précédentes, dans lequel ladite étape de dépôt comprend le dépôt dudit mélange sur un composant de turbine à gaz.
